Europäisches Patentamt

European Patent Office

Office européen des brevets

(11) Veröffentlichungsnummer: **0 082 419**

**A2**

(12) # EUROPÄISCHE PATENTANMELDUNG

(21) Anmeldenummer: 82111401.4

(22) Anmeldetag: 09.12.82

(51) Int. Cl.³: **H 01 L 29/06**
**H 01 L 29/74**

(30) Priorität: 23.12.81 DE 3151141

(43) Veröffentlichungstag der Anmeldung:
29.06.83 Patentblatt 83/26

(84) Benannte Vertragsstaaten:
CH DE FR GB LI

(71) Anmelder: SIEMENS AKTIENGESELLSCHAFT
Berlin und München Wittelsbacherplatz 2
D-8000 München 2(DE)

(72) Erfinder: Kirschner, Fritz, Dipl.-Ing.
Siedlerstrasse 47a
D-8044 Lohhof(DE)

(72) Erfinder: Sagi, Ludwig, Dipl.-Ing.
Wilhelm-Diessweg 13
D-8000 München 81(DE)

(54) Halbleiterbauelement mit hoher Stossstrombelastbarkeit.

(57) Zur Erzielung guter Durchlaßeigenschaften müssen schnelle Thyristoren eine möglichst geringe Mittelzonendicke haben. Werden solche Bauelemente durch mit Passivierungsmittel (18) gefüllte, in die Oberfläche eingeätzte, die pn-Übergänge (14, 15) durchdringende Gräben (16, 19) passiviert, werden die für die Chips verwendeten großflächigen Halbleiterscheiben gegen Bruch außerordentlich anfällig. Hohe mechanische Stabilität bei guten Durchlaßeigenschaften lassen sich miteinander vereinbaren, wenn der die Gräben (16, 19) aufnehmende Randbereich (6) dicker als der die Durchlaßeigenschaften bestimmende Mittelbereich (5) ausgebildet ist.

FIG 1

0082419

SIEMENS AKTIENGESELLSCHAFT
Berlin und München

Unser Zeichen
VPA

81 P 1 1 9 9 E

**Halbleiterbauelement mit hoher Stoßstrombelastbarkeit**

Die Erfindung bezieht sich auf ein Halbleiterbauelement
mit einem Halbleiterkörper mit den Merkmalen:

Der Halbleiterkörper hat zwei Hauptflächen und mindestens
einen pn-Übergang;
der pn-Übergang ist durch eine mit Passivierungsmaterial
bedeckte Grabenflanke begrenzt, die von der dem pn-Übergang am nächsten liegenden Hauptfläche des Halbleiterkörpers ausgeht;
der Halbleiterkörper ist auf beiden Hauptflächen mit
Elektroden versehen;
der Halbleiterkörper hat ein Mittelteil mit einer ersten
Dicke und einen Randbereich, der dicker ist als das Mittelteil.

Solche Halbleiterbauelemente sind z. B. in der DE-OS
27 18 773 beschrieben worden. Bei der Herstellung geht
man von einer großflächigen Halbleiterscheibe aus. Zunächst werden Dotierstoffe eindiffundiert, die die Halbleiterzonen bilden. Dann werden von der ersten und zweiten Hauptfläche ausgehende, sich rechtwinklig kreuzende
Gräben erzeugt, die die pn-Übergänge unterbrechen. Die
Halbleiterscheibe wird dann nach einer ersten Variante
durch in den Gräben liegende, sich kreuzende Trennschnitte in kleinflächige Halbleiterbauelemente zerteilt. Nach einer zweiten Variante werden die pn-Übergänge durch geschlossene ringförmige Gräben begrenzt,
während die Trennschnitte auf zwischen den Gräben der
einzelnen Halbleiterbauelemente liegenden Verbindungs-

Hab 1 Dx / 21.12.1981

stegen durchgeführt werden. Die Verbindungsstege sind
gegenüber den Gräben erhaben ausgeführt und erhöhen die
mechanische Stabilität der großflächigen Halbleiterscheibe.

Schnelle Halbleiterbauelemente, insbesondere schnelle
Thyristoren, erhalten Rekombinationszentren in hohen
Konzentrationen. Wegen der damit einhergehenden kurzen
Trägerlebensdauer lassen sich die Verluste in Durchlaßrichtung nur dann gering halten, wenn die Mittelzone
möglichst dünn gemacht wird. Eine dünne Mittelzone und
damit ein dünner Halbleiterkörper kommt außerdem der
Forderung nach hoher Stoßstrombelastbarkeit entgegen,
da aus diesem die Wärme schneller abgeführt werden kann
als aus einem dicken Halbleiterkörper.

Werden Halbleiterbauelemente mit geringer Dicke der Mittelzone durch mit Passivierungsmaterial gefüllte Gräben
passiviert, die von einer oder von beiden Hauptflächen
des Halbleiterkörpers ausgehen, so verbleibt zwischen
dem Boden der genannten Gräben und der gegenüberliegenden Hauptfläche der Halbleiterscheibe bzw. zwischen den
zwei einander gegenüberliegenden Gräben derartig wenig
Halbleitermaterial, daß eine solche Scheibe stark bruchgefährdet ist.

Der Erfindung liegt die Aufgabe zugrunde, ein Halbleiterbauelement der oben erwähnten Gattung so weiterzubilden, daß eine hohe mechanische Stabilität der Scheibe
bei guten Durchlaßeigenschaften erreicht wird.

Dies wird dadurch erreicht, daß die dem Mittelteil zugekehrte Flanke des Grabens im Randbereich liegt.

Weiterbildungen der Erfindung sind Gegenstand der Unteransprüche.

Die Erfindung wird an Hand eines Ausführungsbeispiels in Verbindung mit den Fig. 1 bis 7 näher erläutert. Es zeigen:

Fig. 1 einen Schnitt durch ein erstes Ausführungsbeispiel,

Fig. 2 eine Aufsicht auf eine großflächige Halbleiterscheibe, aus der eine Vielzahl von Halbleiterkörpern nach Fig. 1 ausgeschnitten wird,

Fig. 3 einen Schnitt durch ein zweites Ausführungsbeispiel,

Fig. 4 die Aufsicht auf eine großflächige Halbleiterscheibe, aus der eine Vielzahl von Halbleiterkörpern nach Fig. 3 ausgeschnitten wird,

Fig. 5 bis 7 Schnitte durch drei weitere Ausführungsbeispiele.

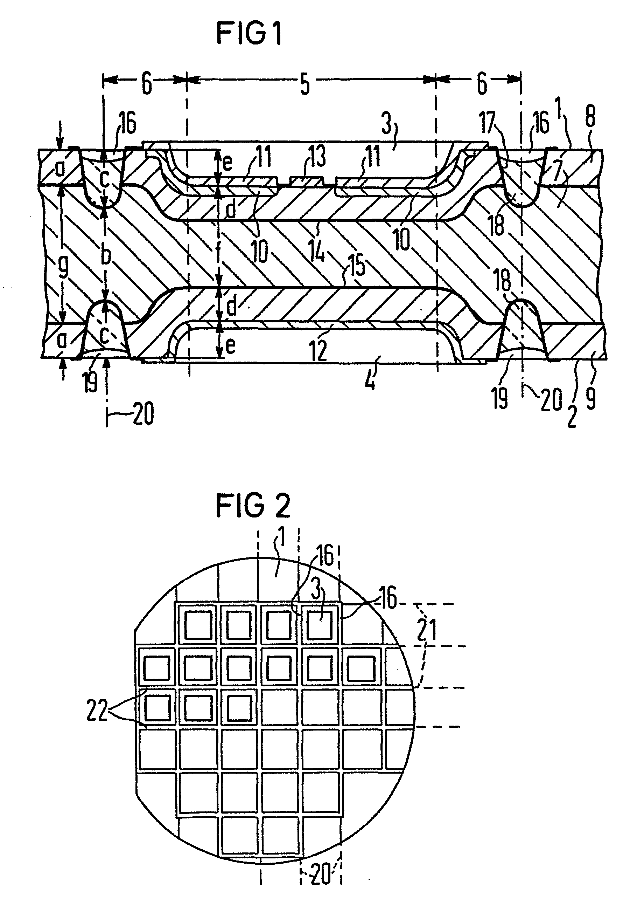

In Fig. 1 ist ein Halbleiterkörper eines Thyristors dargestellt. Der Halbleiterkörper hat eine obere Hauptfläche 1 und eine untere Hauptfläche 2. In den Hauptflächen 1, 2 sind wannenförmige Vertiefungen 3 bzw. 4 vorgesehen. Der Halbleiterkörper ist in ein Mittelteil 5 mit einer ersten gegebenen Dicke und in einen Randbereich 6 unterteilt, der dicker als der Mittelteil 5 ist. Der Randbereich 6 ist durch das Vorhandensein zweier Wannen 3, 4 dicker ausgebildet als das Mittelteil. Ein dickerer Randbereich läßt sich aber auch erreichen, wenn eine der Hauptflächen eben ausgebildet und nur eine einzige Wanne vorgesehen ist. Die Fläche des Mittelteils 5 ist dabei im wesentlichen durch den Boden der Wanne 3 bzw. der Wanne 4 bestimmt. Der Halbleiterkörper weist zwei Halbleiterzonen 8, 9 auf, die eine Mittelzone 7 zwischen sich einschließen. Diese Zonen werden nach Herstellung der Wannen 3 und 4 z. B. durch Eindiffundieren von Dotierstoffen erzeugt. Der Halbleiterkörper hat noch eine vierte Zone 10, die von der Wanne 3 aus eindiffundiert wird. Auf der Zone 10 ist eine Elektrode 11 angeordnet, die ausgehend vom Mittelteil 5 bis in den Randbereich 6 hineinragt. Sie kontaktiert dort auch die Zone 8 und bildet somit den für einen Thyristor erforderlichen Nebenschluß. Die Zone 9 ist mit einer Elektrode 12 kontaktiert, die ebenfalls bis in den Randbereich 6 hineinragt. Die Zone 8 ist mit einer Steuerelektrode 13 kontaktiert. Die Zonen 7, 8 und 7, 9 sind durch zwei pn-Übergänge 14 bzw. 15 getrennt. Die Leitfähigkeit der Zonen ist von oben nach unten z. B. $n^+pnp$.

Der pn-Übergang 14 ist durch eine Flanke 17 eines im Randbereich 6 liegenden Grabens 16 begrenzt, der von der Hauptfläche 1 in den Halbleiterkörper hineinreicht. Dieser Graben wird üblicherweise durch Ätzen hergestellt. Der pn-Übergang 15 wird durch die dem Mittelteil 5 zugekehrte Flanke eines im Randbereich 6 liegenden Grabens 19 begrenzt, der von der Hauptfläche 2 in den Halbleiterkörper hineinreicht. Die Gräben 16, 19 sind mit Passivierungsmaterial 18, z. B. mit Glas, gefüllt.

Der Halbleiterkörper ist im Mittelteil 5 bezüglich der elektrischen Eigenschaften, insbesondere der Durchlaßeigenschaften und der Freiwerdezeit des Halbleiterbauelements optimiert. Er weist hier eine relativ geringe Dicke auf, so daß die Durchlaßverluste trotz niedriger Trägerlebensdauer gering und die Stoßstrombelastbarkeit hoch ist. Die Gräben 16, 19 liegen, wie bereits erwähnt, im dickeren Randbereich 6 des Halbleiterkörpers, so daß die mechanische Stabilität des Halbleiterbauelements selbst und der großflächigen Scheibe, aus der es hergestellt wird, nicht nachteilig beeinflußt wird.

Aus Fig. 2 ist zu sehen, daß aus einer großflächigen Halbleiterscheibe viele Halbleiterbauelemente gemäß Fig. 1 hergestellt werden. Diese Halbleiterbauelemente sind elektrisch durch die erwähnten, auf der Oberseite sichtbaren Gräben 16 und durch rechtwinklig dazu verlaufende Gräben 22 voneinander getrennt. Die einzelnen Halbleiterbauelemente werden nach der Dotierung, nach der Passivierung und Kontaktierung durch in den Gräben 16 und 22 vorgenommene Schnitte 20 bzw. 21 voneinander getrennt.

Ein brauchbares Halbleiterbauelement, das z. B. als Schaltthyristor für ein elektronisches Blitzlichtgerät Anwendung findet, hat beispielsweise eine Gesamtdicke von 250 $\mu$m. Die Dicke a der Zonen 8, 9 kann 40 $\mu$m betragen, so daß die Zone 7 im Randbereich eine Dicke von 170 $\mu$m hat. Die Gräben 16, 19 können beispielsweise jeweils 70 $\mu$m tief sein, so daß zwischen den Gräben eine Reststärke von 110 $\mu$m verbleibt. Macht man die Wannen 3, 4 jeweils 45 $\mu$m tief, so verbleibt für die Zone 7 im Mittelteil 5 eine Dicke von 80 $\mu$m. Dies reicht für eine Sperrspannung von ca. 600 V aus. Bei einer Freiwerdezeit von 4 $\mu$s, was z. B. einer Golddotierung von ca. $10^{14}$ cm$^{-3}$ entspricht, wurde bei einem Strom von 2 A/mm$^2$ lediglich ein Spannungsabfall von 1,2 V gemessen. Die Stoßstrombelastbarkeit wird insbesondere dann günstig beeinflußt, wenn die Wanne 3 z. B. bis zum Rand mit Lotmaterial aufgefüllt wird, ohne daß es zu einem Kurzschluß zwischen den Elektroden 11 und 13 kommt. Die Elektrode 12 in der Wanne 4 kann mittels einer sockelartig ausgebildeten Grundplatte kontaktiert werden.

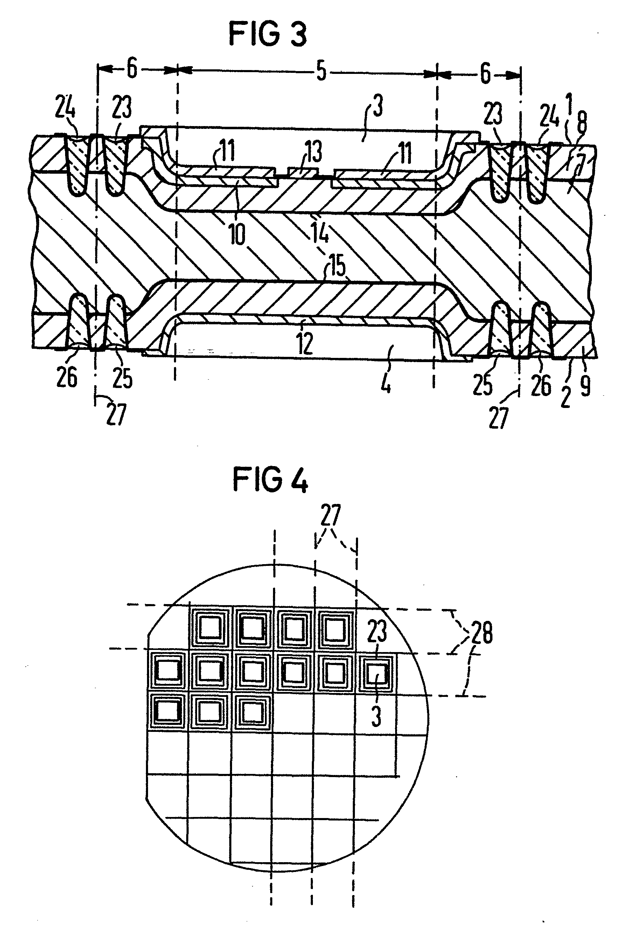

Das Halbleiterbauelement nach Fig. 3 unterscheidet sich von dem nach Fig. 1 durch jeweils einen im Randbereich 6 auf der Ober- und Unterseite liegenden vollständigen Graben 23 bzw. 25, der das Mittelteil 5 umgibt (Fig. 4). Die Gräben 24 bzw. 26 gehören zu den angrenzenden Halbleiterbauelementen. Die einzelnen Halbleiterbauelemente werden zwischen den Gräben 23, 24 bzw. 25, 26 durch Trennschnitte 27 und 28 (Fig. 4) getrennt. Die pn-Übergänge 14, 15 werden dabei ebenfalls durch die dem Mittelteil zugekehrten Flanken der Gräben begrenzt und durch das die Grabenflanken bedeckende Passivierungsmaterial passiviert. Für eine günstige Feldstärkeverteilung ist es empfehlenswert, daß die pn-Übergänge wenigstens etwa senkrecht (70 bis 90°) zu den Flanken der Gräben an die Grabenflanken anstoßen.

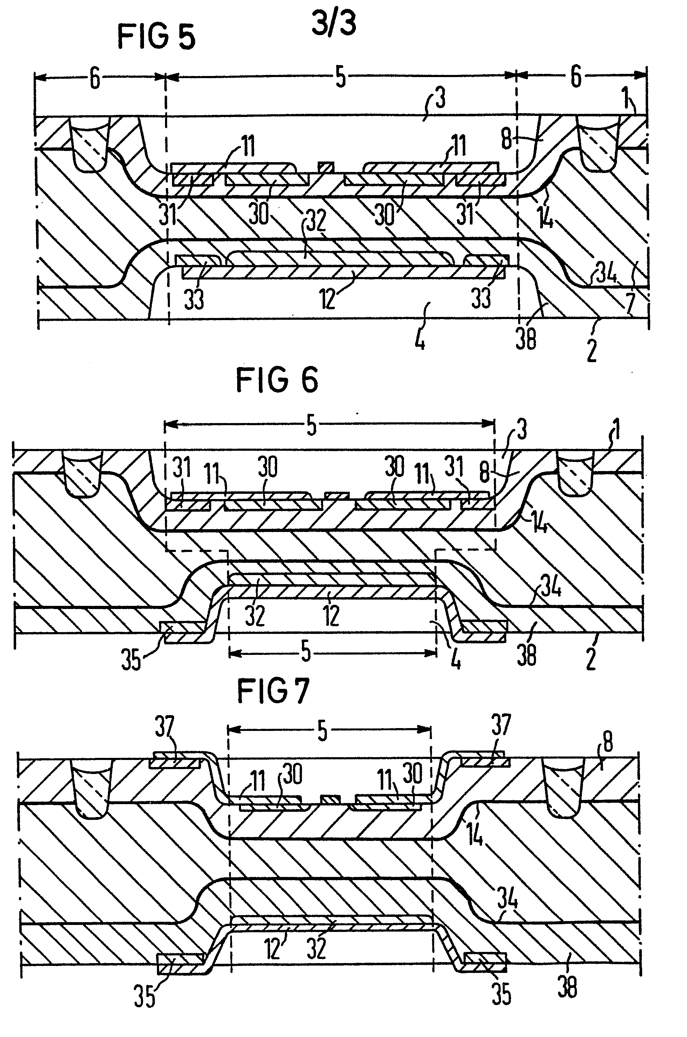

In den Fig. 1 und 3 wurden Thyristoren dargestellt. Es ist jedoch auch möglich, die Erfindung für andere Halbleiterbauelemente, z. B. Dioden, zu verwenden. In den Fig. 5 bis 7 ist ein unsymmetrischer Thyristor mit rückwärts leitender Diode dargestellt. Gleiche oder funktionsgleiche Teile sind hier mit gleichen Bezugszeichen wie in den Fig. 1 und 3 versehen. Der Halbleiterkörper nach Fig. 5 hat eine kollektorseitige Emitterzone 30, die z. B. n-leitend ist. In die Zone 8 ist außerdem eine $n^+$-leitende Zone 31 eingebettet, die zur rückwärts leitenden Diode gehört. An die Zone 8 schließt sich die schwach n-leitende Zone 7 an. Darauf folgt eine stärker n-dotierte Zone 38, die dem Verlauf der Hauptfläche 2 folgt. Die Grenze zwischen den Zonen 7 und 38 ist durch eine Linie 34 veranschaulicht. In die Zone 38 ist von der Wanne 4 her eine stark p-leitende Zone 32 eingebettet, die die anodenseitige Emitterzone des Thyristors darstellt. Neben der Zone 32 liegt eine stark n-leitende Zone 33, die ebenfalls zur rückwärts leitenden Diode gehört. Die Zonen 30 und 31 sind durch die Elektrode 11 und die Zonen 32 und 33 durch die Elektrode 12 kontaktiert. Alle Zonen und die Elektroden liegen im Mittelteil 5 des Halbleiterkörpers.

Der Halbleiterkörper nach Fig. 6 unterscheidet sich von dem nach Fig. 5 dadurch, daß die zur Diode gehörenden stark n-dotierten Zonen 35 im dicken Randbereich des Halbleiterkörpers liegen. Sie sind durch die Elektrode 12 kontaktiert, die in den Randbereich 6 hineinreicht. Die Wanne 4 hat hier kleinere Abmessungen als die Wanne 3. Dementsprechend ist der Mittelbereich 5 auf der Seite der Hauptfläche 2 kleiner als auf der Seite der Hauptfläche 1.

In Fig. 7 sind die stark dotierten zur Diode gehörenden Zonen im Randbereich des Halbleiterkörpers angeordnet. Sie sind mit 35 bzw. 37 bezeichnet.

Die zur rückwärts leitenden Diode gehörenden Zonen können die zum Thyristor gehörenden Zonen beispielsweise ringförmig umgeben, sie können auch streifenförmig neben den gleichfalls streifenförmig ausgebildeten Thyristorzonen angeordnet sein. Die Entscheidung, welche der Ausführungsform nach den Fig. 5 bis 7 angewendet wird, richtet sich danach, welches Schaltverhalten die rückwärts leitende Diode haben soll. Die Anordnung nach Fig. 5 wird man wählen, wenn die rückwärts leitende Diode Punch-through-Verhalten und entsprechend steilen Rückstromabriß zeigen soll. Die Diode nach Fig. 7 wird Break-down-Verhalten zeigen mit einem relativ sanft abklingenden Rückstrom. Die mechanische Stabilität ist in alen drei Fällen die gleiche. Sie ist auch höher als bei den Thyristoren nach Fig. 1 bis 4, da hier nur auf einer Seite Gräben vorgesehen sind.

7 Figuren
11 Patentansprüche

Patentansprüche

1. Halbleiterbauelement mit einem Halbleiterkörper mit den Merkmalen:

Der Halbleiterkörper hat zwei Hauptflächen (1, 2) und mindestens einen pn-Übergang (14);
der pn-Übergang ist durch eine mit Passivierungsmaterial bedeckte Grabenflanke (17) begrenzt, die von der dem pn-Übergang am nächsten liegenden Hauptfläche (1) des Halbleiterkörpers ausgeht;
der Halbleiterkörper ist auf beiden Hauptflächen mit Elektroden (11, 12, 13) versehen;
der Halbleiterkörper hat ein Mittelteil (5) mit einer ersten Dicke und einen Randbereich (6), der dicker ist als das Mittelteil,
d a d u r c h   g e k e n n z e i c h n e t ,
daß die dem Mittelteil (5) zugekehrte Flanke (17) des Grabens (16) im Randbereich (6) liegt.

2. Halbleiterbauelement nach Anspruch 1,   d a d u r c h   g e k e n n z e i c h n e t ,   daß im Randbereich (6) ein vollständiger Graben (23) liegt, der mindestens bis zur Höhe des pn-Übergangs mit Passivierungsmaterial gefüllt ist.

3. Halbleiterbauelement nach Anspruch 1,   d a d u r c h   g e k e n n z e i c h n e t ,   daß im Randbereich (6) ein halber Graben liegt und daß die dem Mittelteil (5) zugekehrte Flanke (17) des Grabens (16) das Mittelteil (5) umgibt.

4. Halbleiterbauelement nach einem der Ansprüche 1 bis 3 mit einem zweiten pn-Übergang (15), der zwischen dem ersten pn-Übergang (14) und der zweiten Hauptfläche (2) liegt und der durch eine von der zweiten Hauptfläche aus-

**0082419**

gehende, mit Passivierungsmaterial bedeckte, dem Mittelteil zugewandte Flanke eines zweiten Grabens (19, 25) begrenzt ist, d a d u r c h  g e k e n n z e i c h n e t ,  daß auch die Flanke des zweiten Grabens (19, 25) im Randbereich des Halbleiterkörpers liegt.

5. Halbleiterbauelement nach Anspruch 4, d a d u r c h  g e k e n n z e i c h n e t ,  daß das Mittelteil (5) durch zwei einander gegenüberliegende Wannen (3, 4) dünner als der Randbereich (6) ist.

6. Halbleiterbauelement nach Anspruch 5, d a d u r c h  g e k e n n z e i c h n e t ,  daß die pn-Übergänge (14, 15) von den Flanken der Gräben ausgehend in Richtung des Mittelteils (5) wannenförmig ausgebildet sind, derart, daß ihre Abstände (f) im Mittelteil (5) geringer sind als die Abstände (g) im Randbereich (6).

7. Halbleiterbauelement nach Anspruch 6, d a d u r c h  g e k e n n z e i c h n e t ,  daß in eine der äußeren Zone (8) eine Zone entgegengesetzten Leitungstyps (10) eingebettet ist, und daß sich diese Zone bis in den Randbereich (6) erstreckt.

8. Halbleiterbauelement nach Anspruch 6 oder 7, d a - d u r c h  g e k e n n z e i c h n e t ,  daß sich die Elektroden (11, 12) bis in den Randbereich erstrekken.

9. Halbleiterbauelement nach Anspruch 1, d a d u r c h  g e k e n n z e i c h n e t ,  daß die pn-Übergänge (14, 15) wenigstens annähernd senkrecht zu den Flanken der Gräben (16, 19; 23, 25) an diese anstoßen.

10. Halbleiterbauelement nach Anspruch 8,   d a -
d u r c h   g e k e n n z e i c h n e t ,   daß im Randbereich (6) weitere Halbleiterzonen (35, 37) angeordnet
sind, die mit den Elektroden (11, 12) kontaktiert sind.

11. Halbleiterbauelement nach Anspruch 8,   d a -
d u r c h   g e k e n n z e i c h n e t ,   daß im Mittelteil (5) weitere Halbleiterzonen (31, 33) angeordnet
sind, die mit den Elektroden (11, 12) kontaktiert sind.

0082419

1/3

FIG 1

FIG 2

FIG 3

FIG 4

3/3

0082419

FIG 5

FIG 6

FIG 7